Europäisches Patentamt

European Patent Office

Office européen des brevets

(11) Veröffentlichungsnummer: **0 282 981**
**A2**

## EUROPÄISCHE PATENTANMELDUNG

(21) Anmeldenummer: **88104128.9**

(22) Anmeldetag: **15.03.88**

(51) Int. Cl.⁴: **H03K 5/02** , H03K 6/04 , H03K 17/16

(30) Priorität: **16.03.87 DE 3708499**

(43) Veröffentlichungstag der Anmeldung: **21.09.88 Patentblatt 88/38**

(84) Benannte Vertragsstaaten: **DE FR GB IT**

(71) Anmelder: **SGS Halbleiter-Bauelemente GmbH**
**Haidling 17 Postfach 11 80**
**D-8018 Grafing b. München(DE)**

(72) Erfinder: **Reichmeyer, Hans**
**Mühltal 2**
**D-8018 Grafing b. München(DE)**
Erfinder: **Stockinger, Josef**
**Schleissheimer Strasse 231**
**D-8000 München 40(DE)**

(74) Vertreter: **Klunker . Schmitt-Nilson . Hirsch**
**Winzererstrasse 106**
**D-8000 München 40(DE)**

(54) **Digitale Gegentakt-Treiberschaltung.**

(57) Digitale-Gegentakt-Treiberschaltung mit zwei von einer Daten-Steuerschaltung abwechselnd leitend gesteuerten Ausgangstransistoren, an deren gemeinsamen Verbindungspunkt eine zu treibende Last angeschlossen ist. Zwischen die Steuerelektrode eines jeden der beiden Ausgangstransistoren und die Daten-Steuerschaltung ist je eine flankensteilheitsvermindernde, freigabeabhängige Verzögerungsschaltung geschaltet. Dabei ist der Ausgang einer jeden Verzögerungsschaltung mit einem Freigabeeingang der jeweils anderen Verzögerungsschaltung verbunden. Die Verzögerungszeiten der beiden Verzögerungsglieder sind mindestens so lang wie die zeitliche Breite der steilheitsverminderten Impulsflanken.

Fig.1

## Digitale Gegentakt-Treiberschaltung

Die Erfindung betrifft eine digitale Gegentakt-Treiberschaltung gemäß Oberbegriff des Anspruchs 1.

Bei dem Bestreben, Mikroprozessoren und damit arbeitende Mikrocomputer immer schneller zu machen, sind die Flanken der Datenimpulse sehr steil geworden. Dies führt bei einigen Anwendungen zu Störungen von Schaltungen oder Geräten außerhalb des Mikrocomputers. Beispielsweise führen derart schnelle Datenimpulsflanken im Automobilbereich zu Störungen von Autoradios.

Störungen treten insbesondere bei Verwendung von CMOS-Mikroprozessoren auf. Bei den dabei verwendeten Gegentakt-Ausgangsstufen kommt es im Übergangsbereich zwischen dem Leitendschalten des einen und dem Sperren des anderen Transistors zu Quer-oder Kurzschlußströmen, weil dann vorübergehend beide Transistoren leitend sind. Insbesondere dann, wenn an mehreren Ausgängen gleichzeitig solche Querströme auftreten, kann es zu erheblichen, kurzzeitigen Strombelastungen der Spannungsversorgungsquelle und damit ebenfalls zu impulsförmigen Störsignalen kommen.

Bei einer bekannten Lösung zur Überwindung des Problems hat man einerseits zwischen die beiden Pole der Spannungsversorgungsquelle einen Kondensator geschaltet, um die störenden Versorgungsstromspitzen zu glätten, und hat man andererseits jedem Ausgang des Mikroprozessors eine Filterschaltung nachgeschaltet, entweder in Form einer RC-Schaltung, wenn es weniger auf verfügbare Ausgangsleistung ankommt, oder in Form einer LC-Schaltung.

Der zwischen die Pole der Versorgungsspannungsquelle geschaltete Kodensator muß einerseits hohe Leistungen verkraften können und andererseits für hohe Frequenzen tauglich sein. Dies bedeutet relativ teuere Bauelemente und relativ hohen Platzbedarf. Jeden Ausgang des Mikroprozessors mit einer RC-oder LC-Filterschaltung zu versehen, führt ebenfalls zu hohen Kosten und Platzaufwand.

Diese bekannten Maßnahmen sind besonders problematisch, wenn der Mikroprozessor in häufig praktizierter Weise Teil einer Dünnschicht-Schaltung ist.

Der Erfindung liegt die Aufgabe zugrunde, eine wesentlich weniger aufwendige und kostenspielige Lösung zur Überwindung der oben geschilderten Störprobleme verfügbar zu machen.

Eine Lösung dieser Aufgabe ist im Anspruch 1 angegeben und kann den Unteransprüchen gemäß vorteilhaft weitergebildet werden.

Durch die erfindungsgemäßen Maßnahmen wird einerseits sichergestellt, daß die an den Ausgängen auftretenden Signalimpulse genügend langsame Flankenübergänge aufweisen, um in andere Schaltungen oder Geräte hineinwirkende HF-Störungen zu unterbinden, und andererseits, daß keine Zeiten gemeinsamen Leitens der beiden Ausgangstransistoren einer Ausgangsstufe auftreten, was die ebenfalls störenden Versorgungsstromimpulse verhindert und insgesamt zu einer geringeren Verlustleistung führt.

Bei einer besonders bevorzugten Ausführungsform der Erfindung befindet sich zwischen dem Ausgang der Treiberstufe und dem Freigabeeingang einer jeden Verzögerungsschaltung je eine Rückkopplungskapazität, mittels welcher sowohl die Flankensteilheitsverminderung als auch die Verzögerungszeit einer jeden Verzögerungsschaltung vom Laststrom der Treiberschaltung abhängig gemacht werden.

Die Verzögerungsschaltungen können je durch eine verzögerungsbehaftete Torschaltung, beispielsweise ein NOR-oder ein NAND-Glied gebildet sein. Es besteht aber auch die Möglichkeit, in beiden Verzögerungsschaltungen je eine monostabile Kippstufe (Monoflop) vorzusehen, von denen eine auf die ansteigenden und die andere auf die abfallenden Impulsflanken verzögernd reagieren, wobei die jeweils andere Flanke unverzögert durchgelassen wird.

Weiterhin besteht die Möglichkeit, in den Verzögerungsschaltungen bistabile Kippschaltungen (Flip-Flops) zu verwenden, die einerseits von den Datenimpulsen und andererseits von separaten Taktimpulsen gesteuert werden. Dabei ist zu berücksichtigen, daß das zeitliche Auftreten der Taktsignale so erfolgen muß, daß die von den Flip-Flops erzeugten Verzögerungszeiten länger sind als die Flankenübergänge der flankensteilheitsverminderten Impulse.

Man kann die Verzögerungsschaltungen entweder durch eine Reihenschaltung aus einem Verzögerungsglied und einem Flankenverminderungsglied aufbauen oder man kann alternativ für die Verzögerungsschaltungen Verzögerungs glieder verwenden, die selbst eine Flankensteilheitsverminderung bewirken, beispielsweise schwachdimensionierte Transistoren in den Torschaltungen.

Die Erfindung wird nun anhand von Ausführungsformen näher erläutert. In den Figuren zeigen:

Fig. 1 eine erste Ausführungsform einer erfindungsgemäßen Gegentakt-Treiberschaltung;

Fig. 2(a) bis (f) Spannungsverläufe an verschiedenen Punkten der in Fig. 1 gezeigten Gegentakt-Treiberschaltung;

Fig. 3 ein Beispiel für eine schaltungsmäßige Realisierung der in Fig. 1 gezeigten Ausführungsform;

Fig. 4 eine zweite Ausführungsform der erfindungsgemäßen Gegentakt-Treiberschaltung;

Fig. 5 ein schaltungsmäßiges Beispiel einer Realisierung der in Fig. 4 gezeigten Ausführungsform; und

Fig. 6(a) und (b) Übertragungskennlinien zweier in Fig. 5 gezeigter Inverter.

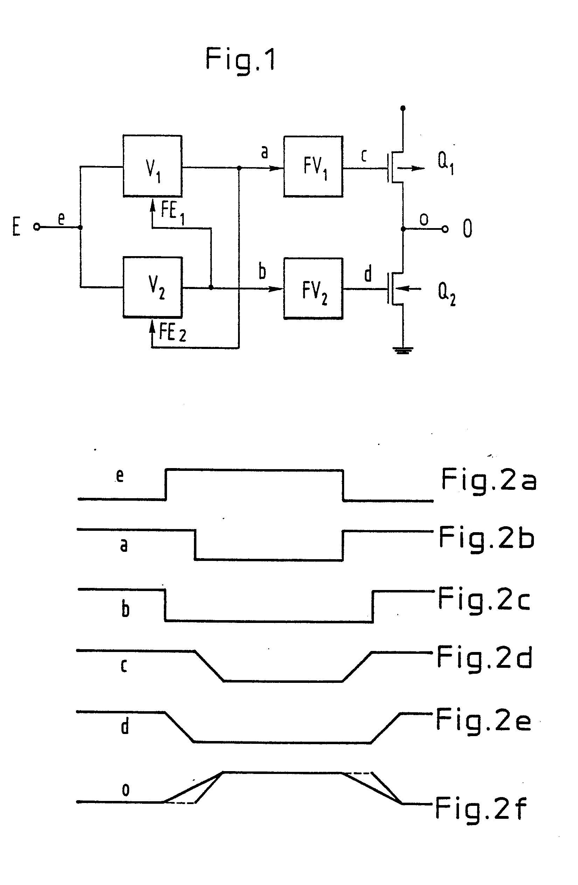

Die in Fig. 1 gezeigte Ausführungsform enthält eine Gegentakt-Treiberschaltung in CMOS-Technik, d.h., mit zwei komplementären MOS-Transistoren Q1 und Q2. Diese befinden sich in Reihenschaltung zwischen den beiden Polen einer Versorgungsspannungsquelle $U_B$.

Der Gate-Elektrode des Transistors Q1 ist eine Reihenschaltung aus einem Verzögerungsglied V1 und einem Flankensteilheitsverminderungsglied FV1 vorgeschaltet. Der Gate-Elektrode des Transistors Q2 ist eine Reihenschaltung aus einem Verzögerungsglied V2 und einem Flankensteilheitsverminderungsglied FV2 vorgeschaltet. Die Eingänge der beiden Verzögerungsglieder V1 und V2 sind gemeinsam an einen Dateneingang E angeschlossen. Die beiden Verzögerungsglieder V1 und V2 sind je freigabeabhängig, d.h., daß sie das an ihrem Eingang anliegende Signal erst nach Freigabe durch ein Freigabesignal an einem Freigabeeingang FE1 bzw. FE2 durchlassen. Der Ausgang des Verzögerungsglieds V1 ist mit dem Freigabeeingang FE2 verbunden, während der Ausgang des Verzögerungsglieds V2 mit dem freigabeeingang FE1 verbunden ist.

Die Buchstaben a bis e und o bezeichnen in den Figuren 2(a) bis (f) gezeigte Spannungssignale.

Es wird nun die Funktionsweise der in Fig. 1 als Blockschaltbild prinzipartig gezeigten Ausführungsform erläutert. Dabei bedeuten H einen hohen Signalwert und L einen niedrigen Signalwert, denen man beispielsweise die Logikwerte "1" bzw. "0" zuordnen kann.

Als Beispiel sei betrachtet, daß das Eingangssignal e von L auf H übergeht. Als Folge davon geht das Ausgangssignal b von V2 von H nach L. Beginnend mit diesem Signalübergang von b nimmt das Signal d von H mit abgeschrägter Flanke bis auf L ab. Damit wird Q2 entsprechend allmählich vom leitenden Zustand in den sperrenden Zustand gebracht.

Der Übergang von H nach L des Signals b gibt das Verzögerungsglied V1 frei, so daß dieses nach einer Verzögerungszeit, die länger ist als die Flankenübergangszeit des Signals d, vom H- in den L-Zustand übergeht.

Diese Flanke des Signals a löst den allmählichen Übergang des Signals c vom H-zum L-Zustand aus. Dadurch wird Q1 entsprechend allmählich vom sperrenden in den leitenden Zustand gebracht.

Den Signalverläufen in Fig. 2 kann man entnehmen, daß durch diese Maßnahme jeder der beiden Transistoren Q1 und Q2 erst dann in den leitenden Zustand gebracht werden kann, wenn der jeweils andere Transistor vollständig gesperrt ist. Am Ausgang O tritt somit ein Ausgangssignal o mit abgeschrägten Flanken gemäß Fig. 2(f) auf. Da die beiden Transistoren Q1 und Q2 nie gleichzeitig eingeschaltet sind, sind auch die störenden Quer- oder Kurzschlußströme vermieden.

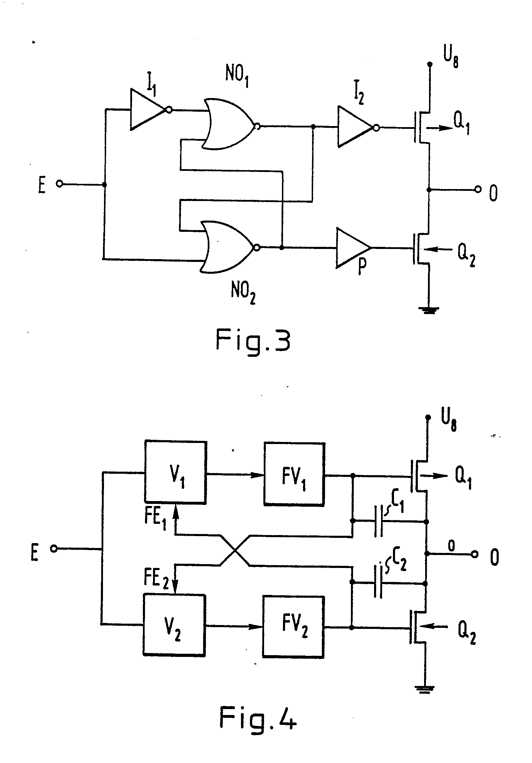

In Fig. 3 ist eine schaltungsmäßige Realisierung der in Fig. 1 gezeigten Ausführungsform gezeigt. Dabei sind die Verzögerungsglieder durch je ein NOR-Glied NO1 bzw. NO2 gebildet. Dabei sind erste Eingänge von NO1 und NO2 mit dem Dateneingang E verbunden, und zwar im Fall von NO1 über einen ersten Inverter I1 und im Fall von NO2 direkt. Zweite Eingänge von NO1 und NO2 sind mit dem Ausgang des jeweils anderen NOR-Glieds NO2 bzw. NO1 verbunden. Die Ausgänge von NO1 und NO2 sind mit den Gate-Elektroden von Q1 und Q2 über einen zweiten Inverter I2 bzw. einen Puffer P verbunden

Die NOR-Glieder NO1 und NO2 sind intern so dimensioniert, daß ihre Signalpfade zwischen den zweiten Eingängen und den Ausgängen verzögerungsbehaftet sind. Der zweite Inverter I2 und der Puffer P sind so dimensioniert, daß sie eine Flankensteilheitsverminderung bewirken. Zu diesem Zweck sind sie beispielsweise mit schwach dimen sionierten Transistoren ausgebildet. D.h., daß der maximale Ausgangsstrom von I2 und P so niedrig bemessen ist, daß die Gate-Kapazität von Q1 bzw. Q2 nur mit der gewünschten steilheitsverminderten Flanke aufgeladen wird.

Die Verzögerungszeit von NO1 bezüglich seines zweiten Engangs muß größer sein als die von P bewirkte Flankensteilheitsverminderung. Gleichermaßen muß die Verzögerungszeit von NO2 bezüglich seines zweiten Eingangs größer sein als die von I2 bewirkte Flankensteilheitsverminderung.

Eine zweite Ausführungsform der Erfindung in Form eines Blockschaltbildes ist in Fig. 4 gezeigt. Mit Fig. 1 übereinstimmende Komponenten sind mit gleichen Bezugszeichen bezeichnet.

Im Unterschied zu der Ausführungsform nach Fig. 1 weist die Ausführungsform nach Fig. 4 eine kapazitive Rückkopplung zwischen dem Ausgang O und den Verzögerungsgliedern auf. Zu diesem Zweck ist zwischen den Freigabeeingang des Verzögerungsgliedes V2 und den Ausgangsanschluß O eine erste Rückkopplungskapazität C1 und zwischen den Freigabeeingang des Verzögerungsglieds V1 und den Ausgangsanschluß O eine zweite Rückkopplungskapazität C2 geschaltet. Die nicht mit dem Ausgang O verbundenen Seiten von C1 und C2 sind außerdem mit dem Gate von Q1 bzw. Q2 verbunden.

Die Rückkopplungskondensatoren C1 und C2 bewirken eine Verlangsamung der Umschaltvorgänge der Transistoren Q1 und Q2 und somit eine Verlangsamung der Pegeländerung am Treiber-Ausgangsanschluß O.

Die von den Rückkopplungskondensatoren C1 und C2 bewirkte Verzögerung wirkt sich auch auf eine entsprechend verzögerte Freigabe der Verzögerungsglieder V2 bzw. V1 aus.

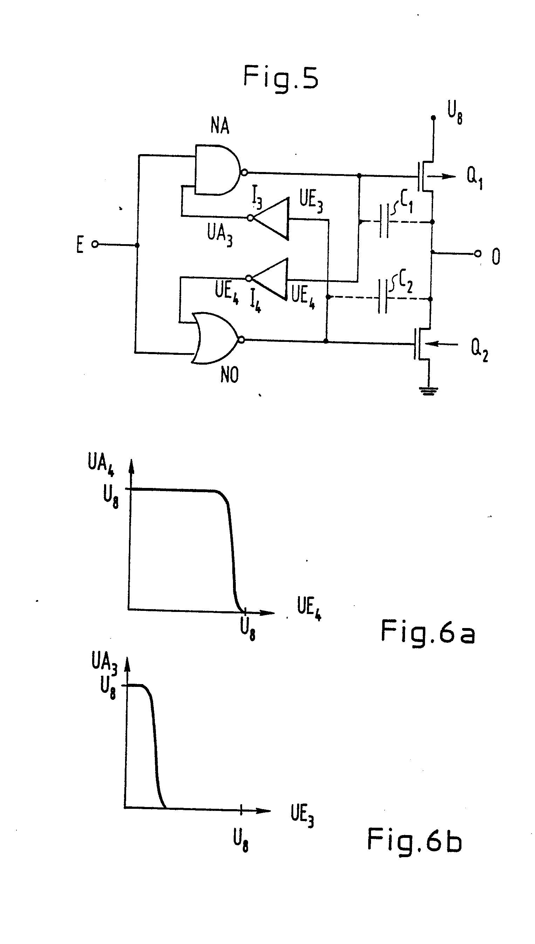

Eine schaltungsmäßige Realilsierung der in Fig. 4 gezeigten Ausführungsform zeigt Fig. 5. Bei dieser Treiberschaltung ist das Verzögerungsglied V1 durch ein NAND-Glied NA gebildet, während das Verzögerungsglied V2 durch ein NOR-Glied NO gebildet ist. Auch in diesem Fall ist wieder ein· erster Eingang des jeweiligen Verzögerungsglieds mit dem Dateneingang E verbunden und ein mit interner Verzögerung behafteter zweiter Eingang mit dem Ausgang des jeweils anderen Verzögerungsglieds verbunden. Und zwar ist der zweite Eingang von NA über einen ersten Inverter I3 mit dem Ausgang von NO und der zweite Eingang von NO über einen zweiten Inverter I4 mit dem Ausgang von NA verbunden. Der Ausgang von NA ist direkt mit dem Gate von Q1 und über einen ersten Rückkopplungskondensator C1 mit dem Ausgangsanschluß O verbunden, während der Ausgang von NO direkt mit dem Gate von Q2 und über einen zweiten Rückkopplungskondensator C2 mit dem Ausgang O verbunden ist.

Die Verzögerung der beiden Verzögerungsglieder kann entweder durch die interne Verzögerung von NA bzw. NO und/oder durch eine durch entsprechende Schaltungsauslegung erzielte Verzögerung der Inverter I3 und I4 erreicht werden. Die Flankensteilheitsverminderung wird durch die Dimensionierung von NA und NO bewirkt.

Fig. 6(a) und (b) zeigen das Übertragungsverhalten der Inverter I3 bzw. I4, das zu dem gewünschten Gesamtverhalten der Schaltung hinsichtlich Querstromunterdrückung führt. Gemäß Fig. 6(a) soll der Inverter I4 erst dann vom H-Zustand zum L-Zustand übergehen, wenn sein Eingangssignal deutlich oberhalb der halben Versorgungsspannung liegt. Im Gegensatz dazu soll gemäß Fig. 6(b) der Inverter I3 schon von seinem H-Zustand in seinen L-Zustand übergehen, wenn sein Eingangssignal noch deutlich unter der halben Versorgungsspannung liegt.

## Ansprüche

1. Digitale Gegentakt-Treiberschaltung, insbesondere für Mikroprozessor-Ausgangsstufen, mit zwei von einer Daten-Steuerschaltung abwechselnd leitend gesteuerten Ausgangstransistoren (Q1, Q2), an deren gemeinsamen Verbindungspunkt (O) eine zu treibende Last anschließbar, ist, und mit Flankensteilheitsverminderungsschaltungen (FV1, FV2), die je zwischen die Steuerelektrode eines der beiden Ausgangstransistoren und die Daten-Steuerschaltung geschaltet sind, dadurch **gekennzeichnet**, daß den Flankensteilheitsverminderungsschaltungen (FV1, FV2) je eine freigabeabhängige Verzögerungsschaltung (V1, FV1 bzw. V2, FV2; NO1, I2 bzw. NO2P; NA, I3 bzw. NO, I4) zugeordnet ist, daß der Ausgang einer jeden Verzögerungsschaltung mit einem Freigabeeingang (FE1, FE2) der jeweils anderen Verzögerungsschaltung verbunden ist, · und daß die Verzögerungszeiten der beiden Verzögerungsglieder mindestens so lang wie die zeitliche Breite der steilheitsverminderten Pulsflanken ist.

2. Gegentakt-Treiberschaltung nach Anspruch 1, dadurch gekennzeichnet, daß die Verzögerungsschaltungen je durch eine verzögerungsbehaftete Torschaltung (NO1, NO2; NA, NO) gebildet sind, die einen mit der Daten-Steuerschaltung verbundenen ersten Eingang und einen mit dem Ausgang der jeweils anderen Torschaltung verbundenen zweiten Eingang aufweist.

3. Gegentakt-Treiberschaltung nach Anspruch 1, dadurch gekennzeichnet, daß die Verzögerungsschaltungen je durch eine Torschaltung gebildet sind, die einen mit der Datensteuerschaltung verbundenen ersten Eingang und einen mit einer gesonderten Verzögerungssignalgeberschaltung verbundenen zweiten Eingang aufweisen.

4. Gegentakt-Treiberschaltung nach einem der Ansprüche 1 bis 3, dadurch gekennzeichnet, daß die Verzögerungsschaltungen je durch eine Reihenschaltung aus einem Verzögerungsglied (V1, V2; NO1, NO2; NA, NO) und einem Flankensteilheitsverminderungsglied (FV1, FV2; I2, P; NA, I3, NO, I4) gebildet sind.

5. Gegentakt-Treiberschaltung nach Anspruch 4, dadurch gekennzeichnet, daß die zweiten Eingänge der Verzögerungsschaltung je mit dem Verbindungspunkt zwischen dem Verzögerungsglied (V1, V2; NO1, NO2) und dem Flankensteilheitsverminderungsglied (FV2 bzw. FV1; P bzw. I2) des jeweils anderen Verzögerungsglieds verbunden sind.

6. Gegentakt-Treiberschaltung nach Anspruch 4, dadurch gekennzeichnet, daß die zweiten Eingänge der Verzögerungsglieder (V1, V2) je mit dem Ausgang des Flankensteilheitsverminderungsgliedes (FV2 bzw. FV1) der jeweils anderen Verzögerungsschaltung verbunden sind.

7. Gegentakt-Treiberschaltung nach Anspruch 6, dadurch gekennzeichnet, daß zwischen den gemeinsamen Verbindungspunkt (O) der beiden Ausgangstransistoren (Q1, Q2) und den Verbindungspunkt zwischen Verzögerungsglied (V1, V2) und Flankensteilheitsverminderungsglied (FV1, FV2) einer jeden Verzögerungsschaltung je ein Rückkopplungskondensator (C1 bzw. C2) geschaltet ist.

8. Gegentakt-Treiberschaltung nach Anspruch 7, dadurch gekennzeichnet, daß die Rückkopplungskondensatoren (C1, C2) durch die parasitären Drain-Gate-Kapazitäten der Ausgangstransistoren (Q1, Q2) gebildet sind.

9. Gegentakt-Treiberschaltung nach einem der Ansprüche 1 bis 7, dadurch gekennzeichnet, daß die Verzögerungsglieder (V1, V2, NO1, NO2, NA, NO) je einen Freigabeeingang besitzen, der es erlaubt beide Verzögerungsglieder abzuschalten und damit beide Ausgangstransistoren (Q1, Q2) in den nicht-leitenden Zustand zu schalten.

Fig.1

Fig.2a

Fig.2b

Fig.2c

Fig.2d

Fig.2e

Fig.2f

Fig.3

Fig.4

## Fig.5

Fig.6a

Fig.6b